(19) Europäisches Patentamt

European Patent Office

Office européen des brevets

(11) Veröffentlichungsnummer: **0 178 387 B1**

(12) **EUROPÄISCHE PATENTSCHRIFT**

(45) Veröffentlichungstag der Patentschrift: **07.10.92**

(21) Anmeldenummer: **85108766.8**

(22) Anmeldetag: **13.07.85**

(51) Int. Cl.⁵: **H01L 29/52**, H01L 29/743

(54) **Abschaltbares Leistungshalbleiterbauelement.**

(30) Priorität: **19.10.84 CH 5016/84**

(43) Veröffentlichungstag der Anmeldung:
**23.04.86 Patentblatt 86/17**

(45) Bekanntmachung des Hinweises auf die
Patenterteilung:
**07.10.92 Patentblatt 92/41**

(84) Benannte Vertragsstaaten:
**CH DE FR GB IT LI NL SE**

(56) Entgegenhaltungen:
**EP-A- 0 038 238**
**EP-A- 0 121 068**
**US-A- 4 037 245**
**US-A- 4 170 502**

**SOLID-STATE ELECTRONICS, Band 23, Nr. 11, November 1980, Seiten 1101-1105, Oxford, GB; J. HOMOLA et al.: "Turn-off-type field-controlled thyristor"**

**INTERNATIONAL ELECTRON DEVICES MEETING, San Francisco, Ca., 9.-12. Dezember 1984, Seiten 439-442, IEEE, New York, US; P. ROGGWILLER et al.: "A highly interdigitated gto power switch with recessed gate structure"**

(73) Patentinhaber: **BBC Brown Boveri AG
Haselstrasse
CH-5401 Baden(CH)**

(72) Erfinder: **Broich, Bruno, Dr.
Pilgerstrasse 83
CH-5405 Baden(CH)**
Erfinder: **Gobrecht, Jens, Dr.
Brühlstrasse 37
CH-5412 Gebenstorf(CH)**
Erfinder: **Roggwiller, Peter, Dr.
Puentstrasse 16
CH-8173 Neerach-Riedt(CH)**
Erfinder: **Voboril, Jan
Landschreiberstrasse 2
CH-5415 Nussbaumen(CH)**

**Beschreibung**

Die vorliegende Erfindung betrifft einen feldgesteuerten Thyristor gemäss dem Oberbegriff des Anspruchs 1. Ein solches Bauelement ist z.B. aus der Druckschrift US-A-4,037,245 bekannt. Ein ähnliches Bauelement ist auch in der DE-A-28 55 546 beschrieben.

Feldgesteuerte Leistungshalbleiterbauelemente sind als unterschiedliche Strukturen und unter verschiedenen Bezeichnungen bekannt. Innerhalb dieser bekannten Bauelemente werden hauptsächlich zwei Funktionstypen unterschieden, nämlich unipolare Strukturen wie z.B. Feldeffekttransistoren vom MOSFET- oder JFET-Typ mit Majoritätsträgerleitung, sowie Bauelemente mit bipolarer Trägerinjektion wie z.B. der Feldgesteuerte Thyristor FCT (Field Controlled Thyristor) oder der Statische Induktionsthyristor SITh (Static Induction Thyristor).

Für Anwendungen im Bereich hoher Leistungen sind aus physikalischen Gründen vor allem die letztgenannten bipolaren Strukturen von Interesse, deren Wirkungsweise in den eingangs genannten Druckschriften sowie in der DE-A-30 02 526 näher erläutert wird.

Einschlägige Druckschriften sind ferner die DE-A-29 32 043, die DE-A-28 24 133, IEEE Trans. ED-29 (1982), S.1560, IEDM Techn. Digest 1984, S.439, und die EP-A-0 121 068.

Während bei einem herkömmlichen GTO mit relativ grober Gate-Kathodenstruktur (siehe z.B. die US-A-4,170,503 oder Fig. 11 mit p-dotierter Schicht 43 aus der EP-A-0 038 238) das Abschalten dadurch erzeugt wird, dass mit einem starken Gatestromimpuls Ladungsträger aus den überschwemmten inneren Gebieten abgesaugt werden und so der inhärente regenerative Schaltmechanismus unterbrochen wird, beruht die Wirkungsweise der herkömmlichen feldgesteuerten Strukturen in der Regel auf der Anwendung des JFET-Prinzips für die Steuerung: In fein verteilten Gate- oder Steuerzonen werden durch Anlegen einer negativen Gatespannung Gebiete mit Ladungsträgerverarmung erzeugt, die sich mit steigender Gatespannung in ein den Strom leitendes Kanalgebiet ausdehnen und schliesslich durch Abschnüren des Kanalgebietes den Stromfluss unterbrechen.

Dem Abschnürvorgang wirkt die am Bauelement anliegende Anodenspannung entgegen, so dass zum Blockieren bzw. Abschalten bei zunehmender Anodenspannung auch eine zunehmende Gatespannung erforderlich ist. Das Verhältnis zwischen der Anodenspannung und der zur Blockierung notwendigen Gatespannung wird als Blockierverstärkung bezeichnet.

Zwischen der Blockierverstärkung und der geometrischen Anordnung und Auslegung der Gatezonen besteht nun ein enger Zusammenhang, der sich daraus ergibt, dass zum Blockieren einer bestimmten Spannung mittels der angelegten Gatespannung ein "Durchgriff" durch den feldgesteuerten Kanal verhindert werden muss.

Die positive Raumladung in einer JFET-Struktur mit n-dotiertem Kanal bewirkt im blockierenden Zustand eine positive Krümmung der zugehörigen Potentialflächen. Um jedoch eine Injektion von Elektronen aus dem kathodenseitigen $n^+$-Emitter in den Kanal zu verhindern, darf das Potential an dieser Stelle nicht grösser als Null werden. Das kann erreicht werden, wenn die Krümmung der Potentialfläche in axialer Richtung im Kanal negativ gemacht werden kann.

Zu diesem Zweck muss bei den bekannten Bauelementen durch die negative Gatespannung an den $p^+$-Gatebereichen eine entsprechend grosse positive Krümmungskomponente in lateraler Richtung erzeugt werden. Der Betrag dieser Komponente wird nun aber, ausser von der Gatespannung, wesentlich vom Abstand der benachbarten Gatebereiche bestimmt. Daraus folgt, dass in einer Struktur der bekannten Art eine Erhöhung der Blockierverstärkung prinzipiell nur durch Verringern der Abstände zwischen den Gatebereichen, d.h. durch eine noch feinere Unterteilung der Gate-Kathodenstruktur erreicht werden kann.

Aufgabe der vorliegenden Erfindung ist es nun, einen feldgesteuerten Thyristor anzugeben, der gegenüber einem feldgesteuerten Thyristor herkömmlicher Art unter der Voraussetzung gleicher Gate-Kathodengeometrie eine wesentlich höhere Blockierverstärkung aufweist.

Die Aufgabe wird bei einem Thyristor der eingangs genannten Art durch die Merkmale aus dem Kennzeichen des Anspruchs 1 gelöst.

Der Kern der Erfindung besteht darin, die erforderliche negative Krümmung der Potentialflächen im n-Kanal dadurch zu erzeugen, dass bei einem feldgesteuerten Thyristor mit vertikal strukturierter Kathodenoberfläche und sich auch über die Seitenwände der Gräben erstreckenden Gatebereichen diese Gatebereiche in eine horizontale durchgehende, niedrig p-dotierte Zwischenschicht eingebettet sind,

Die zwischen den n-leitenden Kathodenbereichen und den p-leitenden Gatebereichen an den Seitenwänden der Gräben entstehenden pn-Uebergänge müssen so ausgelegt sein, dass sie die Gate-Kathodenspannung sperren können. Dann wird beim Anlegen der negativen Blockierspannung der Laststrom blockiert und die Anodenspannung gesperrt. Dicke und Dotierungskonzentration der p-Zwischenschicht werden so gewählt, dass schon bei vergleichsweise kleinen Anodenspannungen und offenem Gatekontakt die entsprechende Raumladungszone am $n^+$-Emitter anstösst und damit den Thyristor durchschaltet.

Die Erfindung wird nachfolgend anhand von in Zeichnungen dargestellten Ausführungsbeispielen näher erläutert.

Dabei zeigt:

Fig. 1 die Struktur eines feldgesteuerten Thyristors mit vertikal strukturierter Gate-Kathodenstruktur in Teilansicht,

Fig. 2 einen Thyristor mit der Struktur nach Fig. 1 in komplettiertem Zustand,

Fig. 3 einen Thyristor mit an der Oberfläche liegendem Gate und p-Zwischenschicht,

Fig. 4 einen erfindungsgemässen Thyristor entsprechend Fig. 1 bzw. 2 mit p-Zwischenschicht,

Fig. 5 berechnete Aequipotentiallinien für eine Struktur gemäss Fig. 1 im blockierenden Zustand,

Fig. 6 entsprechende Aequipotentiallinien für eine Struktur gemäss Fig. 4 im blockierenden Zustand,

Fig. 7 eine Darstellung zweckmässiger Prozessschritte zur Herstellung einer Struktur wie in Fig. 1 bzw. 2, und

Fig. 8 die Abhängigkeit der Blockierverstärkung $\beta$ von der Tiefe $Y_G$ der Gräben in Strukturen gemäss Fig. 1 bzw. 2.

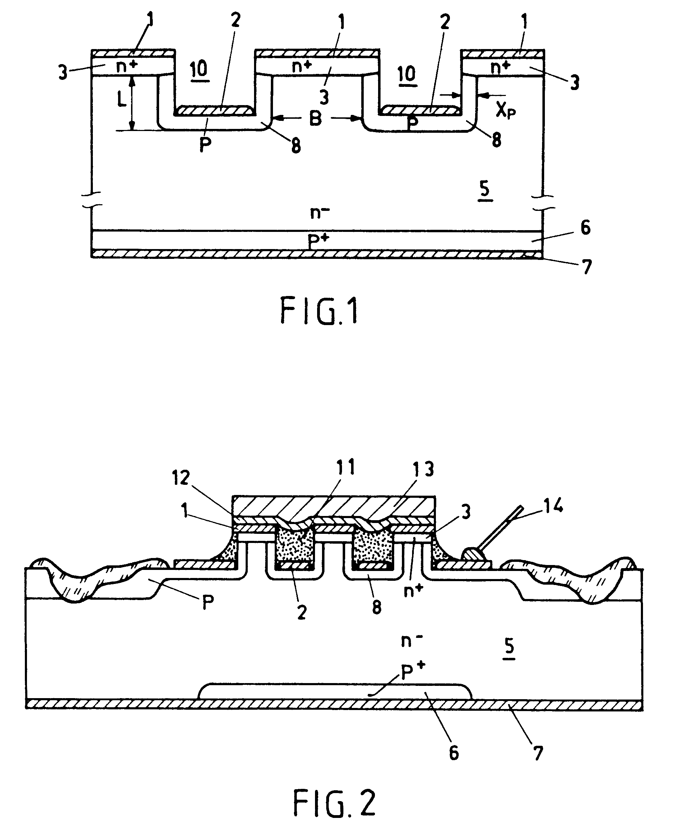

In Fig. 1 ist ein Thyristor mit vertikal strukturierter Kathodenfläche dargestellt. Er umfasst eine $p^+$-dotierte Anodenschicht 6, eine darüberliegende $n^-$-dotierte Kanalschicht 5 und auf der Kathodenseite eine fein unterteilte Gate-Kathodenstruktur, die sich aus abwechselnd angeordneten p-dotierten Gatebereichen 8 und $n^+$-dotierten Kathodenbereichen 3 zusammensetzt. Für die Zuführung des Laststromes sind Kathodenkontakte 1 und Anodenkontakte 7 vorgesehen, die üblicherweise als aufgedampfte Metallschichten ausgeführt sind.

Die einzelnen Kathodenbereiche 3 sind durch tiefe Gräben 10 voneinander getrennt. Die Gatekontakte 2 sind auf den Böden der Gräben 10 angeordnet und die p-dotierten Gatebereiche 8 erstrecken sich sowohl über die Grabenböden als auch über die Grabenwände.

Durch Anlegen einer negativen Gatespannung $U_{GK}$ an die Gatekontakte 2 entstehen am pn-Uebergang zwischen den Gatebereichen 8 und der Kanalschicht 5 Verarmungsgebiete, die sich in das Kanalgebiet zwischen den Gatebereichen 8 ausdehnen und den zwischen Anodenschicht 6 und Kathodenbereich 3 fliessenden Strom einschnüren, bis er gesperrt ist. An dem Element fällt dann die ganze Anodenspannung $U_{AK}$ ab. Das Verhältnis $U_{AK}/U_{GK} = \beta$ heisst Blockierverstärkung. $\beta$ ist auf komplizierte Weise abhängig von verschiedenen Parametern wie Dicke des Bauelementes, Dotierung in der Kanalschicht 5, Breite $X_E$ der Kathodenbereiche 3 und dem Verhältnis L/B. Dabei ist L der senkrechte Abstand des Ueberganges zwischen den Kathodenbereichen 3 und der Kanalschicht 5 vom Uebergang zwischen dem Gatebereich 8 am Boden der Gräben 10 und der Kanalschicht 5. B ist der Abstand zwischen den benachbarten Uebergängen der Gatebereiche 8 an den Wänden der Gräben 10 zur Kanalschicht 5.

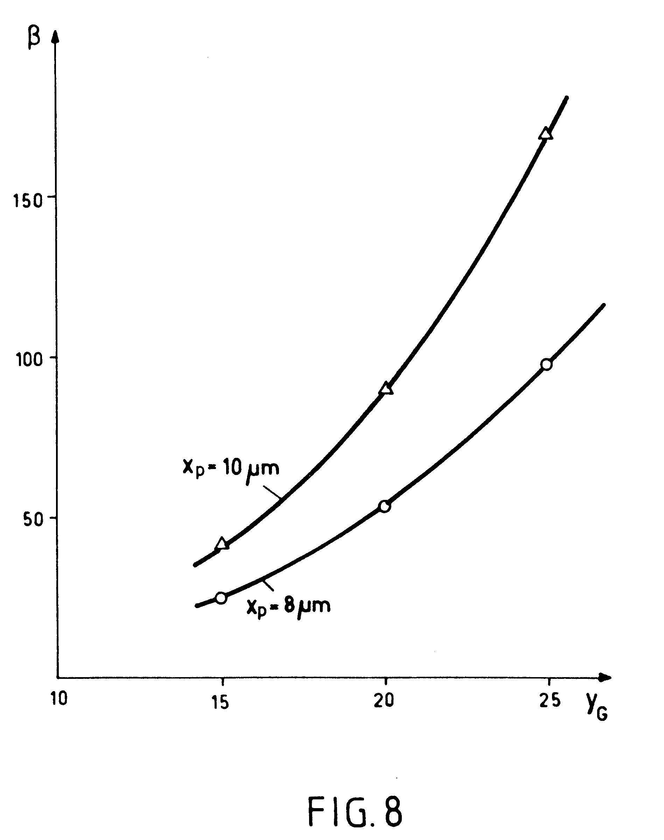

Mit der Struktur gemäss Fig. 1 lassen sich bereits hohe Blockierverstärkungen erzielen, ohne dass die Gate-Kathodengeometrie gegenüber den herkömmlichen Thyristoren wesentlich verändert werden müsste: So erzielt man gemäss Fig. 8 und einer Struktur gemäss Fig. 1 für eine Breite $X_E$ der Kathodenbereiche 3 von 30 um, eine Dicke des Bauelementes von 300 $\mu$, und eine n-Dotierungskonzentration in der Kanalschicht 5 von 3,5 x $10^{13}$ cm$^{-3}$ (= 150$\Omega$cm) bei einer Anodenspannung $U_{AK}$ von 1600 V eine Blockierverstärkung von über 100. Dabei spielen die Grabentiefe $Y_G$ einerseits, und die Tiefe $X_p$ des pn-Ueberganges Gatebereich 8 / Kanalschicht 5 andererseits eine massgebende Rolle.

In Fig. 8 ist die Abhängigkeit der Blockierverstärkung $\beta$ von der Grabentiefe $Y_G$ für den Parameter $X_p$ für die Werte $X_p$ = 8 um und $X_p$ = 10 um dargestellt. Wie ersichtlich, werden für grössere $X_p$, also schmälere n-leitende Kanäle unter den Kathodenbereichen 3, höhere Blockierverstärkungen $\beta$ erzielt als für kleinere $X_p$. Für $Y_G$ = 20 $\mu$m und $X_p$ = 8 $\mu$m ergibt sich z.B. $\beta$ = 55. Für $Y_G$ = 20 $\mu$m und $X_p$ = 10 $\mu$m ergibt sich $\beta$ = 90.

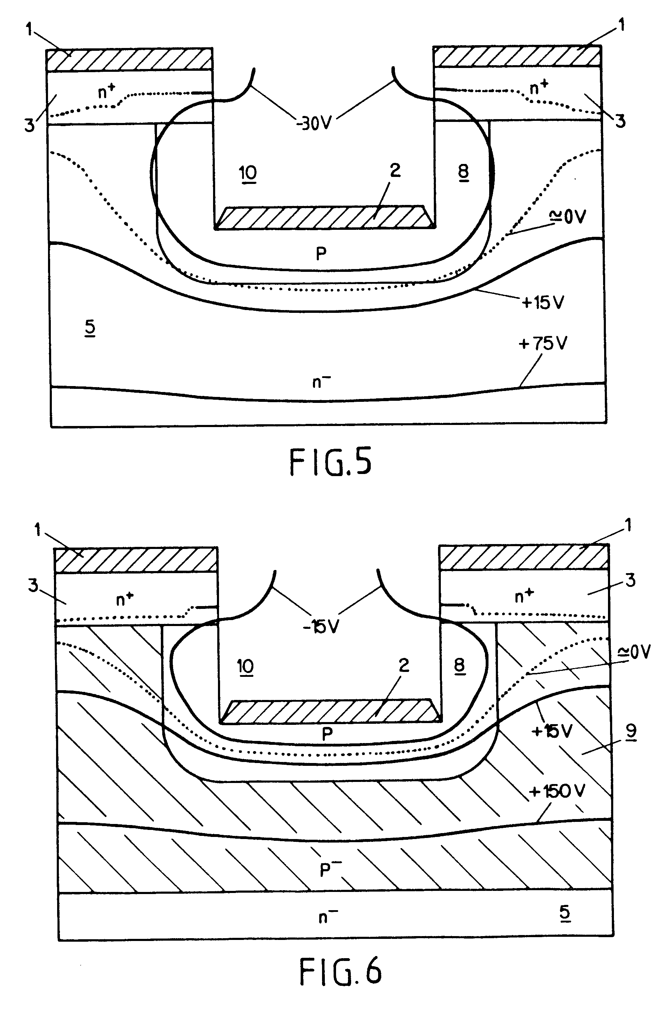

Die Potentialverhältnisse im blockierenden Zustand für eine Gatespannung $U_{GK}$ = -30 V sind in Fig. 5 dargestellt. Wie ersichtlich, wird das Anodenpotential $U_K$ in der Kanalschicht 5 unter den Kathodenbereichen 3 derart modifiziert, dass sich eine Potentialbarriere ergibt, die die Elektronenemission aus dem Kathodenbereich 3 unterbricht. In Fig. 6 ist dargestellt, dass im Falle einer $p^-$-leitenden Kanalschicht 9 der blockierende Zustand für sonst gleiche Geometrien wie in Fig. 5, schon für eine angelegte Gatespannung von $U_{GK}$ = -15 V erreicht wird.

Diese Beispiele verdeutlichen, wie das Blockierverhalten eines feldgesteuerten Thyristors durch die Struktur beeinflusst wird. Je grösser das Verhältnis L/B, bzw. je grösser $X_p$, desto grösser wird die Blockierverstärkung.

Das Bauelement lässt sich mit Erfolg realisieren für Werte $Y_G$ = 10 ... 30 $\mu$m, $X_E$ = 6 ... 40 $\mu$m, $X_p$ = 2 ... 10 $\mu$m, und eine Randkonzentration der Dotierung in den Gatebereichen 8 von höchstens 2 x $10^{16}$ cm$^{-3}$. Dieser letztgenannte Grenzwert ist wichtig, damit der pn-Uebergang zwischen Kathodenbereich 3 und Gatebereich 8 eine negative Gatespannung $U_{GK}$ bis zu 50 Volt aufnehmen, d.h. sperren, kann.

In Fig. 2 ist die Struktur nach Fig. 1 schematisch als komplettes Bauelement mit Randkonturierung und Passivierung dargestellt. Die Gräben 10 sind mit einer Isolierschicht 11 aufgefüllt, welche die Gateelektroden 2 und die Seitenwände abdeckt. Die Isolierschicht besteht vorzugsweise aus einem hinsichtlich Löttemperaturen, mindestens 300 °C, resistenten Material, z.B. Polyimid. Ueber den Kathodenkontakten 1 und der Isolierschicht 11 erstreckt sich eine durchgehende Metallschicht 12, die, damit sie gut lötfähig ist, vorzugsweise aus einer Schichtenfolge aus Cr, Ni und Ag besteht. Die Metallschicht 12 ist stoffschlüssig mit dem metallischen Aussenkontakt 13 verbunden, der z.B. durch Druckkontaktierung in den Lastkreis eingeschaltet werden kann. Die Gatekontakte 2 bilden eine zusammenhängende, die fingerartigen Kathodenbereiche 3 allseitig umschliessende Metallschicht, die von aussen über den Gateanschluss 14 mit elektrischer Spannung beaufschlagt werden kann.

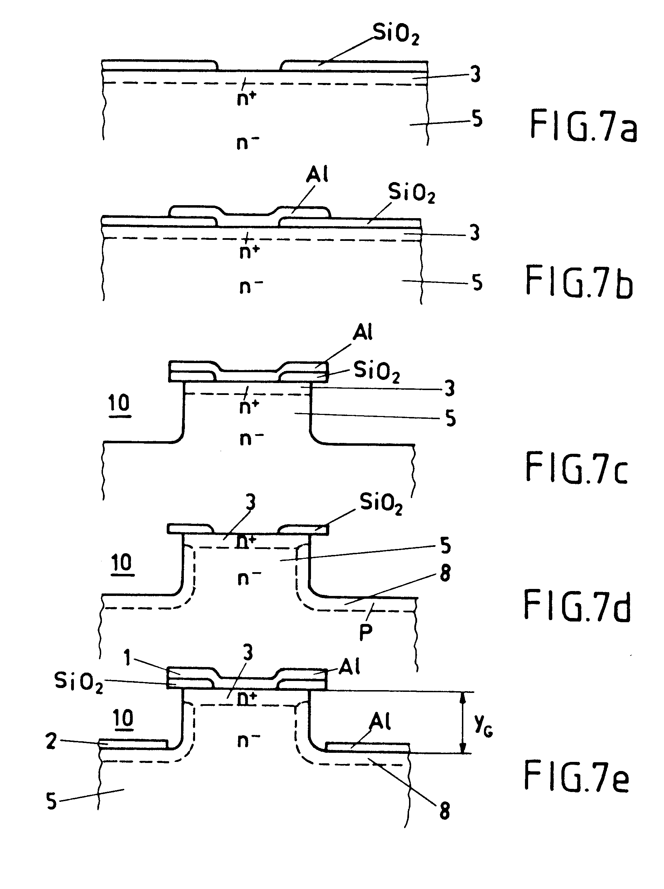

Eine Struktur gemäss Figuren 1 bzw. 2 kann in vorteilhafter Weise durch Prozessschritte hergestellt werden, wie sie in Fig. 7 angedeutet sind:

Ein an seiner Stirnseite mit einer diffundierten $n^{+}$-Schicht versehenes, schwach n-dotiertes Silizium-Substrat (ca. 150 $\Omega$cm) wird zunächst durch thermische Oxidation mit einer $SiO_2$-Deckschicht von ca. 1 um versehen. Mit einer ersten Maske wird in diese $SiO_2$-Schicht in bekannter Weise über dem späteren Kathodenbereichen 3 ein Fenster eingeätzt (Fig. 7a). Sodann wird eine Al-Schicht von ca. 2 $\mu$m Dicke aufgedampft, und mit einer zweiten Maske diese Al-Schicht photolithographisch so strukturiert, dass die späteren Kathodenbereiche 3 selbst, und darüber hinaus ein sich in den Bereich der späteren Gräben 10 erstreckender Randsteg stehen bleiben (Fig. 7b). Sodann werden mittels anisotropem, reaktivem Ionenätzen die Gräben 10 erzeugt, wobei die stehengebliebenen Al-Bereiche als Aetzmasken fungieren (Fig. 7c). Mit dem Ionenätzen werden z.B. 20 $\mu$m abgetragen. Danach werden die Al-Bereiche weggeätzt, und durch Bordiffusion die Gatebereiche 8 mit einer Randkonzentration von ca. $10^{16}$ cm$^{-3}$ und einer Tiefe $X_p$ von ca. 5 $\mu$m erzeugt (Fig. 7d). Schliesslich wird Al gerichtet aufgedampft, um die Kathodenkontakte 1 und die Gatekontakte 2 zu erzeugen (Fig. 7e). Hier spielt nun der in den Graben 10 hineinragende Rand der $SiO_2$-Schicht eine wichtige Rolle: er verhindert, dass sich während des Aufdampfens an den Seitenwänden der Gräben 10 eine leitende Al-Schicht niederschlagen kann, die zu einem Kurzschluss führen würde.

Bei der in Fig. 7 dargestellten Struktur stösst der Gatebereich 8 unmittelbar an den Kathodenbereich 3 an. Dies ist die bevorzugte Ausführungsform. Es ist jedoch auch möglich, die beiden Bereiche 3, 8 voneinander zu trennen, z.B. dadurch, dass am Anfang durch das Fenster in der $SiO_2$-Schicht nur im Raum des späteren Kathodenbereiches 3 eine n-Dotierung eindiffundiert wird. Stattdessen kann der Kathodenbereich 3 auch durch Ionenimplantation nach der Erzeugung der Gatebereiche 8 durch Diffusion von Bor, Al, Ga oder dgl. erzeugt werden.

Wichtig ist in diesem Zusammenhang auch, dass die Wände der Gräben 10 senkrecht zu deren Böden verlaufen: dadurch wird beim gerichteten Al-Aufdampfen im Prozessschritt gemäss Fig. 7e der Abschattungseffekt durch den überstehenden $SiO_2$-Rand erreicht.

Die Abstände L bzw. B in Fig. 1 sind ein Mass für die Länge und die Breite der n-Kanäle unter den Kathodenbereichen 3. Sie lassen sich durch die Tiefe der p-Diffusion bei der Herstellung der Gate-bereiche 8 einstellen.

Je tiefer das eindiffundierte p-Dotierungsprofil ist, d.h. je tiefer der pn-Uebergang Gatebereich 8 / Kanalschicht 5 liegt, bzw. je grösser $X_p$ ist, desto grösser wird dann das Verhältnis L/B, welches, wie erwähnt, ein Mass für die Blockierfähigkeit der Struktur ist.

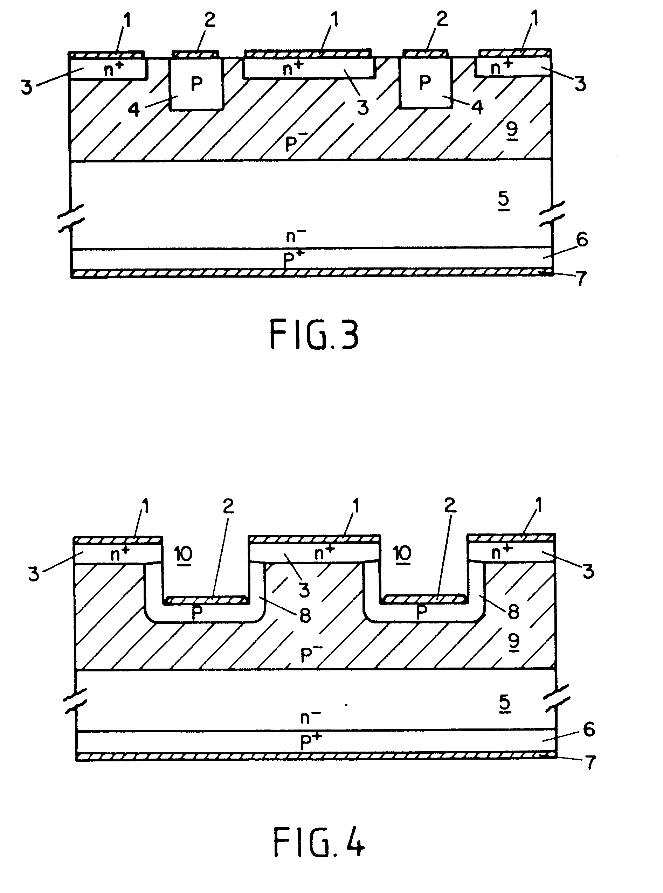

In Fig. 3 und 4 ist in der Kanalschicht 5 zwischen den Gatebereichen 4, 8 eine niedrig p-dotierte Zwischenschicht 9 vorgesehen.

Die Zwischenschicht 9 in der Fig. 3 erstreckt sich nicht nur zwischen den benachbarten Gatebereichen 4, sondern durchgehend auch unter der gesamten Gate-Kathodenstruktur und trennt so nicht nur die Kathodenbereiche 3, sondern auch die Gatebereiche 4 vollständig von der $n^-$-dotierten Basisschicht 5.

Die Zwischenschicht 9 hat vorzugsweise eine p-Dotierung mit einer Konzentration kleiner 1 x $10^{15}$ cm$^{-3}$. Besonders günstig für das Einschalten bei niedriger Spannung ist es, eine Dotierung im Bereich von nur 1 x $10^{14}$ cm$^{-3}$ vorzusehen.

Die Tiefe der Zwischenschicht 9 unter der durch Gatekontakte 2 und Kathodenkontakte 1 definierten Oberfläche wird vorteilhafterweise so gewählt, dass sie etwa der doppelten Tiefe der Gatebereiche 4 entspricht. Sind also beispielsweise Gatebereiche 4 vorgesehen, die ungefähr 15 $\mu$m in das Bauelement hineinreichen, beträgt die Dicke der Zwischenschicht 9 an ihrer dicksten Stelle entsprechend 30 $\mu$m.

In analoger Weise wird erfindungsgemäss die Blockierverstärkung einer Struktur nach Fig. 1, 2 durch eine niedrig p-dotierte Zwischenschicht gemäss dem Ausführungsbeispiel der Fig. 4 erhöht. Die bevorzugten Dotierungskonzentrationen der Zwischenschicht 9 sind in diesem Fall dieselben wie bei dem Bauelement der Fig. 3. Die Tiefe der Zwischenschicht 9 richtet sich hier jedoch nach der Tiefe der Gräben 10 und beträgt vorzugsweise das Doppelte dieser Grabentiefe.

Der Einfluss der erfindungsgemässen niedrig p-dotierten Zwischenschicht 9 auf die Blockierverstärkung soll anhand von berechneten Aequipotentiallinien für eine vertikal abgesetzte Gate-Kathodenstruktur gemäss der Fig. 6 verdeutlicht werden. Für die Berechnung wurden die folgenden Parameter vorausgesetzt, die für eine Struktur der genannten Art typisch sind:

| | |
|---|---|
| Breite der Kathodenbereiche ($X_E$) | 30 $\mu$m |
| Breite der Gräben 10 | 20 $\mu$m |
| Tiefe der Gräben 10 ($Y_G$) | 15 $\mu$m |
| Dicke der gesamten Struktur | 250 $\mu$m |
| Tiefe der Zwischenschicht 9 | 30 $\mu$m |
| Tiefe der Anodenschicht 6 | 10 $\mu$m |
| Tiefe der Kathodenbereiche 3 | 5 $\mu$m |
| Tiefe der Gatebereiche 8 ($X_p$) | 5 $\mu$m |
| Rand-Dotierungskonzentration der Kathodenbereiche 3 | 1 x $10^{19}$ cm$^{-3}$ |
| Rand-Dotierungskonzentration der Anodenschicht 6 | 5 x $10^{18}$ cm$^{-3}$ |
| Rand-Dotierungskonzentration der Gatebereiche 8 | 1 x $10^{16}$ cm$^{-3}$ |
| Rand-Dotierungskonzentration der Zwischenschicht 9 | 8 x $10^{14}$ cm$^{-3}$ |
| Grund-Dotierungskonzentration der Kanalschicht 5 | 7 x $10^{13}$ cm$^{-3}$ |

Aus diesen Parametern wurden nach üblichen Methoden die Aequipotentiallinien innerhalb der Struktur berechnet.

Es ergaben sich die in Fig. 6 ausschnittweise dargestellten Aequipotentiallinien für die Potentialwerte -15 V, 0 V, +15 V und +150 V bei einer Gatespannung $U_{gk}$ = -15 V und einer Anodenspannung von $U_{ak}$ = 1600 V. Die erfindungsgemässe Struktur besitzt eine Blockierfähigkeit bei offenem Gatekontakt von ca. 950 V.

Insgesamt steht mit der Erfindung ein Bauelement zur Verfügung, dass ohne Veränderung der Gate-Kathodengeometrie eine deutlich verbesserte Blockierverstärkung aufweist und mit den üblichen, dem Fachmann der Halbleitertechnologie vertrauten Methoden leicht realisiert werden kann.

**Patentansprüche**

**1.** Feldgesteuerter Thyristor mit einer p-leitenden Anodenschicht (6), einer darüberliegenden, n-leitenden Kanalschicht (5) und einer Mehrzahl von auf der Kathodenseite abwechselnd angeordneten, n-leitenden, mit Kathodenkontakten (1) versehenen Kathodenbereichen (3) und p-leitenden Gatebereichen (8), wobei die Kathodenbereiche (3) durch Gräben (10) voneinander getrennt sind, die Gatebereiche (8) sich sowohl über die Böden als auch über die Seitenwände der Gräben (10) erstrecken, die Kathodenbereiche (3) berühren und auf den Böden der Gräben (10) mit Gatekontakten (2) versehen sind, und die Wände der Gräben (10) senkrecht zu deren Böden verlaufen, dadurch gekennzeichnet, dass
(a) die Gräben (10) zwischen 10 und 30 $\mu$m tief sind;
(b) die Kathodenbereiche (3) zwischen 6 und 40 $\mu$m breit sind;
(c) die Gatebereiche (8) zwischen 2 und 10 $\mu$m dick sind und eine Dotierungskonzentration am Rand von höchstens 2 x $10^{16}$ cm$^{-3}$ aufweisen;
(d) die Gatebereiche (8) in eine horizontal durchgehende, p-dotierte Zwischenschicht (9) mit einer Dotierungskonzentration von kleiner als 1 x $10^{15}$ cm$^{-3}$ eingebettet sind, welche Zwischenschicht (9) die Gatebereiche (8) und Kathodenbereiche (3) von der Kanalschicht (5) trennt; und
(e) der senkrechte Abstand L des Uebergangs zwischen einem n-leitenden Kathodenbereich (3) und der Zwischenschicht(9) vom zum Boden der Gräben (10) parallelen Uebergang eines p-leitenden Gatebereichs (8) zur Zwischenschicht (9) jeweils grösser ist als der senkrechte Abstand B zwischen benachbarten, zu den Wänden der Gräben (10) parallelen Uebergängen der Gatebereiche (8) zur Zwischenschicht (9).

**2.** Feldgesteuerter Thyristor nach Anspruch 1, dadurch gekennzeichnet, dass die Gatekontakte (2) eine zusammenhängende Metallschicht bilden.

**3.** Feldgesteuerter Thyristor nach Anspruch 2, dadurch gekennzeichnet, dass
(a die Kathodenkontakte (1) um mindestens 1 $\mu$m in die Gräben (10) hinein überstehen;

(b die Gräben (10) mit einer Isolierschicht (11) aufgefüllt sind, welche die Gatekontakte (2) und die Seitenwände der Gräben (10) abdeckt; und

(c über den Kathodenkontakten (1) und der Isolierschicht (11) eine durchgehende Metallschicht (12) aufgebracht ist, welche mit den Kathodenkontakten (1) leitend verbunden ist.

4. Feldgesteuerter Thyristor nach Anspruch 3, dadurch gekennzeichnet, dass die Isolierschicht (11) aus Polyimid, die durchgehende Metallschicht (12) aus einer Cr-Ni-Ag-Schichtenfolge, und die Kathodenkontakte (1) und Gatekontakte (2) aus Al bestehen.

5. Verfahren zur Herstellung eines Thyristors nach Anspruch 1, dadurch gekenzeichnet, dass

(a) die Gräben (10) mittels eines maskierten, anisotropen Ionenätzverfahrens und die Kathodenkontakte (1) und Gatekontakte (2) mittels gerichtetem Aufdampfen von Aluminium erzeugt werden; und

(b) vor dem Ionenätzen die Oberfläche der Kathodenbereiche (3) zunächst mit einer $SiO_2$-Schicht und dann mit einer Al-Schicht belegt wird, wobei diese Al-Schicht photolithographisch derart strukturiert ist, dass sie die Kathodenbereiche (3) voll abdeckt und in die Bereiche der Gräben (10) hineinreichende Randstege aufweist, während die Bereiche der Gräben (10) im übrigen offen sind.

## Claims

1. Field-controlled thyristor having a p-type anode layer (6) above which an n-type channel layer (5) is located, and a plurality of n-type cathode regions (3) and p-type gate regions (8), provided with cathode contacts (1) which are alternately arranged at the cathode side, the cathode regions (3) being separated from each other by troughs (10), the gate regions (8) extending both over the bottoms and over the side walls of the troughs (10) touching the cathode regions (3) and being provided on the bottoms of the troughs (10) with gate contacts (2) and the walls of the troughs (10) extending perpendicularly to their bottoms, characterised in that

a) the troughs (10) have a depth of between 10 $\mu$m and 30 $\mu$m

b) the cathode regions (3) have a width of between 6 $\mu$m and 40 $\mu$m,

c) the gate regions (8) have a thickness of between 2 $\mu$m and 10 $\mu$m and a doping concentration at the edge of 2 $\times$ 10$^{16}$ cm$^{-3}$ maximum,

d) the gate regions (8) are embedded in a horizontally continuous intermediate layer (9) which has p-doping with a doping concentration of less than 1 $\times$ 10$^{15}$ cm$^3$, which intermediate layer (9) separates the gate regions (8) and the cathode regions (3) from the channel layer (5); and

e) the vertical distance L of the junction between an n-type cathode region (3) and the intermediate layer (9) from the junction, which is parallel to the bottom of the troughs (10), of a p-type gate region (8) to the intermediate layer (9) is in each case greater than the vertical distance B between adjacent junctions, which are parallel to the walls of the troughs (10), of the gate regions (8) to the intermediate layer (9).

2. Field-controlled thyristor according to Claim 1, characterised in that the gate contacts (2) form a coherent metal layer.

3. Field-controlled thyristor according to Claim 2, characterised in that

a) the cathode contacts (1) project by at least 1 $\mu$m into the troughs (10),

b) the troughs (10) are filled with an insulating layer (11) which covers the gate contacts (2) and the side walls of the troughs (10), and

c) over the cathode contacts (1) and the insulating layer (11) a continuous metal layer (12) is applied which is conductively connected to the cathode contacts (1).

4. Field-controlled thyristor according to Claim 3, characterised in that the insulating layer (11) consists of polyimide, the continuous metal layer (12) consists of a sequence of Cr-Ni-Ag layers and the cathode contacts (1) and the gate contacts (2) consist of Al.

5. Method for producing a thyristor according to Claim 1, characterised in that

a) the troughs (10) are generated by means of a masked and anisotropic ion etching method and the cathode contacts (1) and gate contacts (2) are produced by means of selective vapour deposition of aluminium, and

b) in that before the ion etching process, the surface of the cathode regions (3) is first covered with an SiO₂ layer and then with an Al layer, this Al layer being photo-lithographically structured in such a manner that it fully covers the cathode regions (3) and is provided with edge lands which project into the regions of the troughs (10) whilst the regions of the troughs (10) are otherwise open.

## Revendications

1. Thyristor commandé par le champ, comportant une couche d'anode à conduction p (6), une couche de canal à conduction n surjacente (5) et une pluralité de domaines de cathode (3) pourvus de contacts de cathode (1), à conduction n, disposés du côté de la cathode en alternance avec des domaines de gâchette (8) à conduction p, les domaines de cathode (3) étant séparés les uns des autres par des fosses (10), les domaines de gâchette (8) s'étendant à la fois sur le fond et sur les flancs des fosses (10), les domaines de cathode (3) étant en contact et étant pourvus sur le fond des fosses (10) de contacts de gâchette (2), et les flancs des fosses (10) s'étendant verticalement vers leur fond, caractérisé en ce que

   (a) les fosses (10) ont une profondeur comprise entre 10 et 30 $\mu$m;

   (b) les domaines de cathode (3) ont une largeur comprise entre 6 et 40 $\mu$m;

   (c) les domaines de gâchette (8) ont une épaisseur comprise entre 2 et 10 $\mu$m et présentent une concentration en agent dopant au bord s'élevant tout au plus à $2 \times 10^{16}$ cm$^{-3}$;

   (d) les domaines de gâchette (8) sont noyés dans une couche intermédiaire horizontale continue à dopage p (9) présentant une concentration en agent dopant inférieure à $1 \times 10^{15}$ cm$^{-3}$, la couche intermédiaire (9) séparant les domaines de gâchette (8) et les domaines de cathode (3) de la couche de canal (5); et

   (e) la distance verticale L séparant la jonction entre un domaine de cathode à conduction n (3) et la couche intermédiaire (9) de la jonction parallèle au fond des fosses (10) d'un domaine de gâchette à conduction p (8) à la couche intermédiaire (9), est toujours supérieure à la distance verticale B entre des jonctions voisines des domaines de gâchette (8) à la couche intermédiaire (9), parallèles aux flancs des fosses (10).

2. Thyristor commandé par le champ suivant la revendication 1, caractérisé en ce que les contacts de gâchette (2) forment une couche métallique cohérente.

3. Thyristor commandé par le champ suivant la revendication 2, caractérisé en ce que

   (a) les contacts de cathode (1) débordent d'au moins 1 $\mu$m dans les fosses (10);

   (b) les fosses (10) sont remplies d'une couche isolante (11) qui recouvre les contacts de gâchette (2) et les flancs des fosses (10), et

   (c) sur les contacts de cathode (1) et la couche isolante (11) est appliquée une couche métallique (12) continue qui est connectée de manière conductrice aux contacts de cathode (1).

4. Thyristor commandé par le champ suivant la revendication 3, caractérisé en ce que la couche isolante (11) est en polyimide, la couche métallique continue (12) est faite d'une succession de couches de Cr-Ni-Ag et les contacts de cathode (1) ainsi que les contacts de gâchette (2) sont en Al.

5. Procédé pour la fabrication d'un thyristor suivant la revendication 1, caractérisé en ce que

   (a) les fosses (10) sont produites au moyen d'un procédé de morsure ionique anisotrope avec masque et les contacts de cathode (1) ainsi que les contacts de gâchette (2) sont produits par vaporisage dirigé d'aluminium, et

   (b) avant la morsure ionique, la surface des domaines de cathode (3) est recouverte initialement d'une couche de SiO₂, puis d'une couche de Al, cette couche de Al étant structurée par voie photolithographique d'une manière telle qu'elle recouvre entièrement les domaines de cathode (3) et présente des rebords qui s'étendent dans les domaines des fosses (10), tandis que les domaines des fosses (10) sont pour le reste ouverts.

FIG.1

FIG.2

FIG.3

FIG.4

FIG.5

FIG.6

FIG.7a

FIG.7b

FIG.7c

FIG.7d

FIG.7e

FIG. 8